# DEMANDE DE BREVET EUROPEEN

(11) **EP 4 148 026 A1**
(43) Date de publication de la demande: **15.03.2023**
(21) Numéro de dépôt: 21195595.0
(22) Date de dépôt: 08.09.2021
(51) Int. Cl.: C03C 15/00, C03C 23/00

(54) **PROCÉDÉ DE STRUCTURATION D'UN MARQUAGE ANTI-CONTREFAÇON DANS UN OBJET AU MOINS PARTIELLEMENT TRANSPARENT ET OBJET AU MOINS PARTIELLEMENT TRANSPARENT COMPRENANT UN MARQUAGE ANTI-CONTREFAÇON**

(71) Demandeur: Comadur S.A., 2400 Le Locle (CH)
(72) Inventeur: BOULMAY, Alexis, 25500 Morteau (FR); LE BOUDOUIL, Damien, 25500 Morteau (FR)
(74) Mandataire: ICB SA

(57) **Abrégé**

L'invention concerne un procédé de structuration d'un marquage anti-contrefaçon (18) dans l'épaisseur d'un objet (1) réalisé en un matériau amorphe, semi-cristallin ou cristallin au moins partiellement transparent, l'objet (1) au moins partiellement transparent comprenant une surface supérieure (2) et une surface inférieure (4) qui s'étend à distance de la surface supérieure (2), le procédé comprenant la succession d'étapes qui consistent à :
- se munir de l'objet (1) au moins partiellement transparent nu ;
- munir l'une des surfaces supérieure (2) ou inférieure (4) de l'objet (1) au moins partiellement transparent d'un masque (6) qui définit au moins une ouverture (8) dont le contour correspond au profil du marquage anti-contrefaçon (18) que l'on souhaite structurer, le masque (6) recouvrant la surface de l'objet au moins partiellement transparent aux endroits qui ne doivent pas être structurés ;
- structurer le marquage anti-contrefaçon (18) en bombardant l'objet (1) au moins partiellement transparent au moyen d'un faisceau d'ions (14) mono- ou multichargés à travers la au moins une ouverture (8) du masque (6), les propriétés mécaniques du masque (6) étant suffisantes pour empêcher les ions du faisceau d'ions (14) d'attaquer la surface de l'objet (1) au moins partiellement transparent aux endroits où cette surface supérieure (2) est recouverte par le masque (6) ;
- retirer le masque (6) ;
- passer l'objet au moins partiellement transparent dans un bain (16) au PH basique.

## Description

### Domaine technique de l'invention

La présente invention concerne un procédé de structuration d'un motif à fonction technique ou décorative dans un objet au moins partiellement transparent. La présente invention concerne tout particulièrement un tel procédé de structuration au moyen d'un faisceau d'ions mono- ou multichargés. La présente invention concerne plus particulièrement encore un procédé de structuration d'un motif dans un objet réalisé en un matériau amorphe, semi-cristallin ou cristallin au moins partiellement transparent.

### Arrière-plan technologique

Dans le domaine de l'industrie horlogère en particulier, la lutte contre la contrefaçon est une préoccupation constante. C'est pourquoi les techniques de marquage sont un atout précieux pour la lutte anti-contrefaçon. En matière de marquage anti-contrefaçon dans le domaine de l'horlogerie, on identifie deux niveaux qui sont moins identifiés par les techniques de marquage mises en œuvre que par les techniques utilisées pour lire ces marquages : il faut en effet pouvoir différencier à coup sûr un produit authentique d'un produit contrefait.

Le premier niveau de marquage anti-contrefaçon correspond à des marquages identifiables par tous sans recours à un quelconque appareil de lecture. Bien qu'identifiables par tous, ces marquages tels que des hologrammes n'en sont pas moins dissuasifs car ils sont complexes à reproduire. Ces marquages anti-contrefaçon peuvent également participer à l'esthétique de l'objet sur lequel ils sont apposés. Les marquages anti-contrefaçons de niveau 1 sont habituellement identifiables à l'œil nu. Ils peuvent néanmoins faire intervenir d'autres sens comme le toucher par exemple avec une impression en relief.

Le second niveau de marquage correspond à des marquages qui ne peuvent être identifiés qu'au moyen d'un appareil de lecture. Deux options sont alors possibles : soit le marquage tel qu'un code-barres est visible à l'œil nu mais son décodage nécessite un lecteur. De tels marquages peuvent permettre d'individualiser les lots, les produits et renfermer de nombreuses autres informations. Soit le marquage est invisible. Dans ce cas, le marquage ne peut être révélé qu'à l'aide d'un dispositif de lecture par exemple à infrarouge ou à ultraviolet en agissant sur la longueur d'onde de la lumière.

Paradoxalement, la nature rassurante des marquages anti-contrefaçon visibles ou facilement visibles peut faire le jeu des contrefacteurs car elle peut agir sur la confiance des consommateurs. On rapporte ainsi le cas d'un médicament contrefait comportant un hologramme qui s'est mieux vendu que le médicament original qui n'en comportait pas. Le gros défaut des marquages anti-contrefaçon identifiables par le consommateur sans l'aide d'un appareil de lecture est qu'ils permettent d'identifier immédiatement les objets à contrefaire. Le contrefacteur pourra donc aisément comparer son travail avec l'original. Apposer un marquage anti-contrefaçon visible sur un objet sans nuire à l'esthétique de ce dernier peut également s'avérer problématique. Les marquages anti-contrefaçon invisibles à l'œil nu sont quant à eux plus difficiles à contrefaire, car il faut d'abord que les contrefacteurs identifient leur présence sur les objets. Les méthodes pour réaliser ces marquages invisibles sont néanmoins souvent longues et coûteuses à mettre en œuvre. En outre, pour révéler la présence de tels marquages invisibles à l'œil nu, il est le plus souvent nécessaire de disposer d'un décodeur spécifique. Cela peut donc nécessiter des investissements parfois conséquents, tout particulièrement si l'on veut pouvoir tester des objets provenant de fabricants différents et utilisant des techniques de marquage anti-contrefaçon différentes les unes des autres. Le plus souvent. il n'est donc pas possible de garantir que le décodeur approprié est disponible au moment où l'on souhaite s'assurer de l'authenticité d'un produit donné.

### Résumé de l'invention

La présente invention a pour but de proposer un procédé permettant de structurer de manière fiable et reproductible un marquage anti-contrefaçon dans un objet au moins partiellement transparent.

A cet effet, la présente invention concerne un procédé de structuration d'un marquage anti-contrefaçon dans l'épaisseur d'un objet réalisé en un matériau amorphe, semi-cristallin ou cristallin au moins partiellement transparent, l'objet au moins partiellement transparent comprenant une surface supérieure et une surface inférieure qui s'étend à distance de la surface supérieure, le procédé comprenant la succession d'étapes qui consistent à :
- se munir de l'objet au moins partiellement transparent nu ;
- munir l'une des surfaces supérieure ou inférieure de l'objet au moins partiellement transparent d'un masque qui définit au moins une ouverture dont le contour correspond au profil du marquage anti-contrefaçon que l'on souhaite structurer, le masque recouvrant la surface de l'objet au moins partiellement transparent aux endroits qui ne doivent pas être structurés ;
- structurer le marquage anti-contrefaçon en bombardant l'objet au moins partiellement transparent au moyen d'un faisceau d'ions mono- ou multichargés à travers la au moins une ouverture du masque, les propriétés mécaniques du masque étant suffisantes pour empêcher les ions du faisceau d'ions d'attaquer la surface de l'objet au moins partiellement transparent aux endroits où cette surface est recouverte par le masque ;
- retirer le masque ;
- passer l'objet au moins partiellement transparent dans un bain au pH basique.

Grâce à ces caractéristiques, la présente invention procure un procédé permettant de réaliser un marquage anti-contrefaçon dans l'épaisseur d'un objet au moins partiellement transparent de manière fiable et reproductible. Un tel marquage, imperceptible à l'œil nu, peut être mis en évidence de manière très simple, en l'éclairant au moyen d'une source lumineuse à large spectre, par exemple une source lumineuse du type à diodes électroluminescentes. En effet, en suivant les étapes du procédé selon l'invention, on aboutit à un objet au moins partiellement transparent qui, à l'endroit où a été structuré le marquage anti-contrefaçon, présente une variation de sa réflectivité qui, bien que très faible, est néanmoins suffisante pour que le marquage puisse être perçu lorsqu'on l'éclaire. Par conséquent, l'un des avantages notables de l'invention est qu'il n'est nul besoin de disposer d'un équipement spécifique et souvent coûteux pour pouvoir s'assurer de l'authenticité d'un objet marqué conformément aux enseignements de l'invention. Une simple source lumineuse à large spectre couramment disponible dans le commerce est suffisante. Par ailleurs, le marquage anti-contrefaçon obtenu grâce au procédé selon l'invention est inviolable. Dans le cas où un tel marquage est par exemple structuré dans une glace de montre en saphir, le seul moyen d'altérer ce marquage est de procéder à un polissage de la glace au moyen d'une pâte diamant ou bien de faire fondre cette glace.

Selon un mode particulier de mise en œuvre du procédé selon l'invention. On dépose sur l'une au moins des surfaces supérieure ou inférieure de l'objet au moins une couche antireflet.

Selon un autre mode particulier de mise en œuvre du procédé selon l'invention, l'objet au moins partiellement transparent est réalisé en saphir, en rubis ou en diamant, de préférence de synthèse.

Selon encore un autre mode particulier de mise en œuvre du procédé selon l'invention, l'objet au moins partiellement transparent est réalisé en un matériau organique semi-cristallin.

Selon encore un autre mode particulier de mise en œuvre du procédé selon l'invention, l'objet au moins partiellement transparent est réalisé en verre minéral ou en un matériau organique amorphe.

Selon encore un autre mode particulier de mise en œuvre de l'invention, l'objet au moins partiellement transparent est préalablement lavé.

Selon encore un autre mode particulier de mise en œuvre du procédé selon l'invention, le faisceau d'ions mono- ou multichargés est produit par une source d'ions mono- ou multichargés du type à résonance cyclotron électronique ECR.

Selon encore un autre mode particulier de mise en œuvre de l'invention, l'objet au moins partiellement transparent est bombardé au moyen d'ions azote N, oxygène O, hélium He, carbone C, argon Ar, xénon Xe, tétrafluorure de carbone CF₄ ou méthane CH₄.

Selon encore un autre mode particulier de mise en œuvre de l'invention, les ions sont accélérés sous une tension comprise entre 10 kV et 40 kV et la dose d'implantation ionique est comprise entre 3.10¹⁶ et 6.10¹⁶ ions/cm².

Selon encore un autre mode particulier de mise en œuvre de l'invention, l'objet au moins partiellement transparent est bombardé au moyen d'ions azote N accélérés sous une tension de 28 kV pendant une durée de 1.53 s/cm2, la dose d'implantation ionique étant de 3.5.10¹⁶ ions/cm² et l'intensité du faisceau d'ions étant de 5.5 mA.

Selon encore un autre mode particulier de mise en œuvre de l'invention, le masque est une feuille de matériau dans laquelle le contour du marquage anti-contrefaçon a été découpé, cette feuille de matériau étant ensuite fixée sur la surface supérieure de l'objet au moins partiellement transparent dans laquelle on souhaite structurer le motif.

Selon encore d'autres modes particuliers de mise en œuvre de l'invention :
- le masque déposé sur la surface de l'objet au moins partiellement transparent est une couche métallique créée par métallisation ;
- la métallisation est réalisée par évaporation sous vide au moyen de l'une des techniques suivantes : dépôt physique en phase vapeur (Physical Vapor Déposition ou PVD), dépôt chimique en phase vapeur (Chemical Vapor Déposition ou CVD), dépôt chimique en phase vapeur assisté par plasma (Plasma Enhanced Chemical Vapor Déposition) ;
- la couche métallique est une couche de nitrure de chrome CrN dont l'épaisseur est comprise entre 1 et 1500 nm ;
- la au moins une ouverture dont le contour correspond au profil du marquage anti-contrefaçon que l'on souhaite structurer dans l'objet au moins partiellement transparent est ménagée dans la couche métallique par photolithographie.

Selon encore une autre forme de mise en œuvre de l'invention, l'objet au moins partiellement transparent est une glace de montre.

### Brève description des figures

D'autres caractéristiques et avantages de la présente invention ressortiront plus clairement de la description détaillée qui suit d'un exemple de mise en œuvre du procédé selon l'invention, cet exemple étant donné à titre purement illustratif et non limitatif seulement, en liaison avec le dessin annexé sur lequel :
- la figure 1 est une vue en coupe d'une glace de montre sur une surface supérieure de laquelle est déposée une couche de masquage ;
- la figure 2 est une vue en coupe de la glace de montre de la figure 1 sur laquelle la couche de masquage est recouverte d'une couche de résine photosensible ;
- la figure 3 est une vue en coupe de la glace de montre de la figure 2 sur laquelle la couche de résine photosensible est exposée à la lumière, seules les parties de cette couche de résine photosensible exposées à la lumière polymérisant ;
- la figure 4 est une vue en coupe de la glace de montre de la figure 3 qui illustre le développement de la couche de résine photosensible, seules les parties de cette couche de résine photosensible exposées à la lumière subsistant, tandis que les parties non-exposées à la lumière ont été éliminées ;
- la figure 5 est une vue en coupe de la glace de montre de la figure 4 sur laquelle les parties de la couche de masquage non-recouvertes par la couche de résine photosensible exposée à la lumière ont été éliminées ;
- la figure 6 est une vue en coupe de la glace de montre de la figure 5 sur laquelle ce qui reste de la couche de résine photosensible est éliminé à son tour, la surface supérieure de la glace de montre étant recouverte par endroits de la couche de masquage qui forme le masque dont le contour des ouvertures correspond au profil du marquage anti-contrefaçon que l'on souhaite structurer dans l'épaisseur de la glace de montre ;
- la figure 7 est une vue en coupe de la glace de la figure 6 sur laquelle on procède au marquage anti-contrefaçon de la glace de montre en bombardant la glace de montre au moyen d'un faisceau d'ions à travers les ouvertures du masque ;
- la figure 8 est une vue en coupe de la glace de montre de la figure 7 passée dans un bain au pH basique ;
- la figure 9 illustre la mise en évidence du marquage anti-contrefaçon au moyen d'une source lumineuse ;
- la figure 10 est une vue en coupe de la glace de montre sur les faces avant et arrière de laquelle ont été déposées des couches antireflets.

### Description détaillée de l'invention

La présente invention procède de l'idée générale inventive qui consiste à proposer un procédé de marquage anti-contrefaçon d'un objet au moins partiellement transparent pouvant être intégré sans difficulté particulière dans un cycle de fabrication à grande échelle. Par ailleurs, les marquages structurés conformément au procédé selon l'invention, invisibles à l'œil nu, peuvent être mis en évidence au moyen d'une simple source lumineuse à large spectre dont pratiquement tout le monde dispose. Il n'est donc pas nécessaire, pour pouvoir authentifier les objets marqués conformément à l'invention, de disposer de décodeurs spécifiques souvent coûteux et dont la présence sur le lieu où l'on souhaite effectuer les contrôles n'est pas toujours garantie. De même, les marquages anti-contrefaçon réalisés en accord avec l'invention sont quasi inaltérables, la destruction de l'objet marqué étant souvent la seule solution pour faire disparaître ces marquages.

Dans l'exemple qui suit, on décrit la structuration conformément au procédé de l'invention d'un marquage anti-contrefaçon dans une glace de montre en saphir. Il va de soi que cet exemple est donné à titre purement illustratif et non limitatif seulement et que le présent procédé peut être appliqué au marquage de tout objet au moins partiellement transparent réalisé en un matériau amorphe, semi-cristallin ou cristallin.

Désignée dans son ensemble par la référence numérique générale 1, la glace de montre, réalisée en saphir, comprend une surface supérieure 2 et une surface inférieure 4 qui s'étend à distance de la surface supérieure 2. Dans l'exemple représenté au dessin, le marquage anti-contrefaçon est réalisé dans la surface supérieure 2 de la glace de montre 1. Bien entendu, ce marquage anti-contrefaçon pourrait tout aussi bien être réalisé dans la surface inférieure 4 de cette glace de montre 1.

Après s'être procuré une telle glace de montre 1, on commence par munir la surface supérieure 2 de celle-ci d'un masque 6 qui va définir au moins une ouverture 8 dont le contour correspondra au profil du marquage anti-contrefaçon destiné à être structuré dans l'épaisseur de la glace de montre 1. Selon une première forme d'exécution de l'invention non représentée au dessin, le masque 6 est une feuille de matériau séparée dans laquelle le contour du marquage anti-contrefaçon a été découpé, cette feuille de matériau étant ensuite fixée sur la surface supérieure 2 de la glace de montre 1.

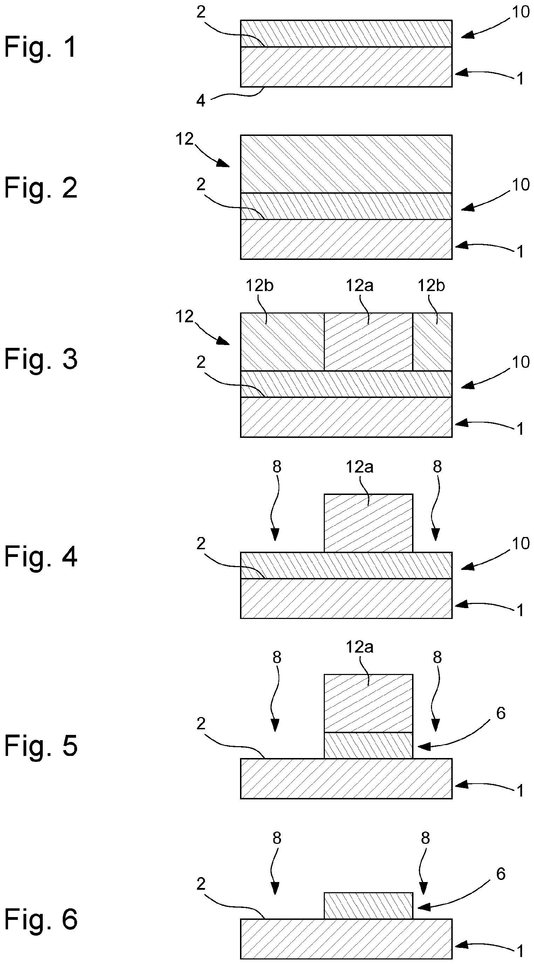

Selon la forme préférée de mise en œuvre du procédé selon l'invention, le masque 6 est réalisé par photolithographie directement sur la surface supérieure 2 de la glace de montre 1. A cette fin, on commence par recouvrir la surface supérieure 2 de la glace de montre 1 d'une couche de masquage 10 d'un matériau dans lequel doit être réalisé le masque 6 (voir figure 1). D'une épaisseur préférentiellement comprise entre 1 et 1500 nm, la couche de masquage 10 peut être réalisée par évaporation sous vide d'un matériau métallique tel que du nitrure de chrome CrₓN_{y}, par exemple CrN, au moyen de l'une des techniques suivantes : dépôt physique en phase vapeur également connu sous la dénomination anglo-saxonne Physical Vapor Déposition ou PVD, dépôt chimique en phase vapeur également connu sous la dénomination anglo-saxonne Chemical Vapor Déposition ou CVD, ou bien encore dépôt chimique en phase vapeur assisté par plasma également connu sous la dénomination anglo-saxonne Plasma Enhanced Chemical Vapor Déposition ou PECVD.

Une fois la couche masquage 10 déposée, celle-ci est recouverte d'une couche de résine photosensible 12 (voir figure 2). Cette couche de résine photosensible 12 est ensuite exposée à la lumière, de sorte que seules les parties de cette couche de résine photosensible 12 exposées à la lumière polymérisent (voir figure 3). Après quoi, la couche de résine photosensible 12 est développée, seules les parties 12a de cette couche de résine photosensible 12 exposées à la lumière subsistant, tandis que les parties 12b non-exposées à la lumière sont éliminées (voir figure 4). Finalement, les parties de la couche de masquage 10 non-recouvertes par la couche de résine photosensible 12 sont éliminées, par exemple par attaque chimique (voir figure 5), puis les parties 12a de la couche de résine photosensible 12 qui ont été exposées à la lumière sont éliminées à leur tour. On obtient ainsi une glace de montre 1 dont la surface supérieure 2 est recouverte par endroits de la couche de masquage 10 qui forme le masque 6 dont le contour de la (ou des) ouvertures 8 correspond au profil du marquage anti-contrefaçon que l'on souhaite structurer dans l'épaisseur de la glace de montre 1 (voir figure 6).

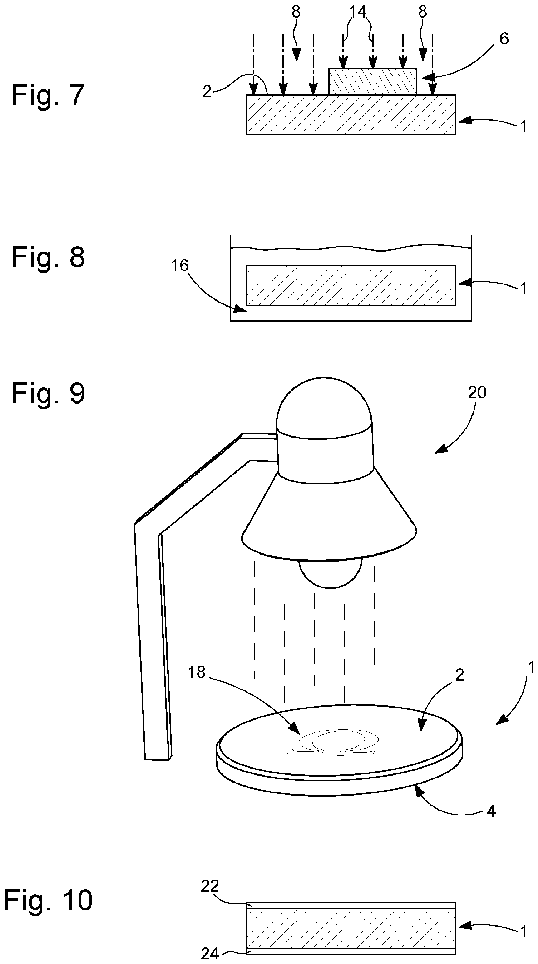

Une fois la couche de masquage 10 convenablement structurée par photolithographie pour former le masque 6, on procède au marquage anti-contrefaçon de la glace de montre 1. A cet effet (voir figure 7), on bombarde la glace de montre 1 au moyen d'un faisceau d'ions 14 mono- ou multichargés à travers la au moins une ouverture 8 du masque 6, les propriétés mécaniques de ce masque 6 étant suffisantes pour empêcher les ions du faisceau d'ions 14 d'attaquer la surface supérieure 2 de la glace de montre 1 aux endroits où cette surface supérieure 2 est recouverte par le masque 6. Selon la forme préférée de mise en œuvre du procédé selon l'invention, la glace de montre 1 est bombardée au moyen d'ions azote N, oxygène O, hélium He, carbone C, argon Ar, xénon Xe ou d'ions carbone C obtenus par ionisation de tétrafluorure de carbone CF₄ ou de méthane CH₄. Pour accélérer ces ions, on peut utiliser une source d'ions mono- ou multichargés du type à résonance cyclotron électronique ECR. De préférence, les ions sont accélérés sous une tension comprise entre 10 kV et 40 kV et la dose d'implantation ionique est comprise entre 3.10¹⁶ et 6.10¹⁶ ions/cm². Dans le cas particulier où la glace de montre 1 est bombardée au moyen d'ions azote N, ceux-ci sont accélérés sous une tension de 28 kV pendant une durée de 1.53 s/cm², la dose d'implantation ionique étant de 3.5.10¹⁶ ions/cm² et l'intensité du faisceau d'ions étant de 5.5 mA.

Après bombardement ionique de la glace de montre 1 pour structurer dans l'épaisseur de celle-ci le marquage anti-contrefaçon désiré, le masque 6 est éliminé, puis la glace de montre 1 est passée dans un bain 16 au pH basique (voir figure 8). Un exemple d'un bain approprié dans lequel la glace de montre 1 peut être passée après structuration du marquage anti-contrefaçon est donné par le produit commercialisé par la société Borer sous la référence deconex OP 141. Il s'agit d'une solution à base d'hydroxyde de potassium dont le pH est égal à 13.

Le marquage anti-contrefaçon 18 obtenu conformément au procédé selon l'invention est imperceptible à l'œil nu mais peut être mis en évidence de manière très simple, en l'éclairant au moyen d'une source lumineuse 20 à large spectre, par exemple une source lumineuse du type à diodes électroluminescentes (voir figure 9). En effet, en suivant les étapes du procédé selon l'invention, on aboutit à une glace de montre 1 transparente mais qui, à l'endroit où a été structuré le marquage anti-contrefaçon 18, présente une variation de sa réflectivité qui, bien que très faible, est néanmoins suffisante pour que le marquage anti-contrefaçon 18 puisse être perçu lorsqu'on l'éclaire au moyen d'une source lumineuse 20. Par conséquent, l'un des avantages notables de l'invention est qu'il n'est nul besoin de disposer d'un équipement spécifique et souvent coûteux pour pouvoir s'assurer de l'authenticité d'un objet marqué conformément aux enseignements de l'invention. A titre d'exemple, une source lumineuse 20 adaptée aux besoins de l'invention est la lampe à usage universel commercialisé par la société TANEO sous la référence STZL 24 R dont la température de la couleur blanche est comprise entre 4700 et 5300°K.

Avant structuration du marquage anti-contrefaçon, la glace de montre 1 peut être préalablement lavée afin de la dégraisser.

Après structuration du marquage anti-contrefaçon dans l'épaisseur de la glace de montre 1, on peut encore déposer une ou plusieurs couches antireflets 22, 24 sur l'une et/ou l'autre des faces supérieure 2 ou inférieure 4 de la glace de montre 1 (voir figure 10). La ou les couches antireflets 22, 24 sont réalisées par exemple au moyen de silice (SiO₂) ou de fluorure de magnésium (MgF₂). Il est possible de combiner des couches en silice avec des couches en fluorure de magnésium. L'épaisseur de ces couches considérées individuellement n'excède habituellement pas 150 nm. D'autres matériaux tels que les oxydes de titane, de tantale, de zircone, de silicium et d'aluminium ainsi que le nitrure de silicium peuvent aussi être utilisés pour la réalisation des couches antireflets. Ces couches antireflets 22, 24 peuvent être déposées par évaporation sous vide. Parmi les techniques de dépôt sous vide envisageables, on peut citer le dépôt physique en phase vapeur (PVD), le dépôt chimique en phase vapeur (CVD), le dépôt chimique en phase vapeur assisté par plasma (PECVD), ou bien encore les techniques de dépôt de couches atomiques, également connues sous leur dénomination anglo-saxonne Atomic Layer Déposition ou ALD. Il est possible de combiner des couches en silice avec des couches en fluorure de magnésium. L'épaisseur de ces couches considérées individuellement n'excède habituellement pas 150 nm. D'autres matériaux tels que les oxydes de titane, de tantale, de zircone, de silicium et d'aluminium ainsi que le nitrure de silicium peuvent aussi être utilisés pour la réalisation des couches antireflets.

Il va de soi que la présente invention n'est pas limitée au mode de mis en œuvre qui vient d'être décrit et que diverses modifications et variantes simples peuvent être envisagées sans sortir du cadre de l'invention tel que défini par les revendications annexées. En particulier, l'invention vient d'être décrite en liaison avec une glace de montre réalisée en saphir. Il va néanmoins de soi que l'invention n'est pas limitée à ce mode particulier de réalisation et qu'elle s'applique à tout type d'objet au moins partiellement transparent réalisé en saphir, en rubis ou en diamant, de préférence de synthèse. L'invention s'applique également à des objets au moins partiellement transparents réalisés en un matériau organique semi-cristallin tel que du verre minéral ou en un matériau organique amorphe.

### Nomenclature

- 1.: Glace de montre
- 2.: Surface supérieure
- 4.: Surface inférieure
- 6.: Masque
- 8.: Ouvertures
- 10.: Couche de masquage
- 12.: Couche de résine photosensible
- 12a.: Parties de la couche de résine photosensible exposées à la lumière
- 12b.: Parties de la couche de résine photosensible non-exposées à la lumière
- 14.: Faisceau d'ions
- 16.: Bain
- 18.: Marquage anti-contrefaçon
- 20.: Source lumineuse
- 22, 24.: Couches antireflets

## Revendications

1. Procédé de structuration d'un marquage anti-contrefaçon (18) dans l'épaisseur d'un objet (1) réalisé en un matériau amorphe, semi-cristallin ou cristallin au moins partiellement transparent, l'objet (1) au moins partiellement transparent comprenant une surface supérieure (2) et une surface inférieure (4) qui s'étend à distance de la surface supérieure (2), le procédé comprenant la succession d'étapes qui consistent à :
- se munir de l'objet (1) au moins partiellement transparent nu ;
- munir l'une des surfaces supérieure (2) ou inférieure (4) de l'objet (1) au moins partiellement transparent d'un masque (6) qui définit au moins une ouverture (8) dont le contour correspond au profil du marquage anti-contrefaçon que l'on souhaite structurer, le masque (6) recouvrant la surface de l'objet (1) au moins partiellement transparent aux endroits qui ne doivent pas être structurés ;
- structurer le marquage anti-contrefaçon en bombardant l'objet (1) au moins partiellement transparent au moyen d'un faisceau d'ions (14) mono- ou multichargés à travers la au moins une ouverture (8) du masque (6), les propriétés mécaniques du masque (6) étant suffisantes pour empêcher les ions du faisceau d'ions (14) d'attaquer la surface de l'objet (1) au moins partiellement transparent aux endroits où cette surface est recouverte par le masque (6) ;
- retirer le masque (6) ;
- passer l'objet (1) au moins partiellement transparent dans un bain (16) au PH basique.

2. Procédé selon la revendication 1, **caractérisé en ce que** l'on dépose sur l'une au moins des surfaces supérieure (2) ou inférieure (4) au moins une couche antireflet (22, 24).

3. Procédé selon l'une des revendications 1 et 2, **caractérisé en ce que** l'objet (1) au moins partiellement transparent est réalisé en saphir, en rubis ou en diamant, de préférence de synthèse.

4. Procédé selon l'une des revendications 1 et 2, **caractérisé en ce que** l'objet (1) au moins partiellement transparent est réalisé en un matériau organique semi-cristallin.

5. Procédé selon l'une des revendications 1 et 2, **caractérisé en ce que** l'objet (1) au moins partiellement transparent est réalisé en verre minéral ou en un matériau organique amorphe.

6. Procédé selon l'une des revendications 1 à 5, **caractérisé en ce que** l'objet (1) au moins partiellement transparent est préalablement lavé.

7. Procédé selon l'une des revendications 1 à 6, **caractérisé en ce que** le faisceau d'ions (14) mono- ou multichargés est produit par une source d'ions mono- ou multichargés du type à résonance cyclotron électronique ECR.

8. Procédé selon la revendication 7, **caractérisé en ce que** l'objet (1) au moins partiellement transparent est bombardé au moyen d'ions azote N, oxygène O, hélium He, carbone C, argon Ar, xénon Xe ou d'ions carbone C obtenus par ionisation de tétrafluorure de carbone CF₄ ou de méthane CH₄.

9. Procédé selon la revendication 8, **caractérisé en ce que** les ions sont accélérés sous une tension comprise entre 10 kV et 40 kV et la dose d'implantation ionique est comprise entre 3.10¹⁶ et 6.10¹⁶ ions/cm².

10. Procédé selon la revendication 9, **caractérisé en ce que** l'objet (1) au moins partiellement transparent est bombardé au moyen d'ions azote N accélérés sous une tension de 28 kV pendant une durée de 1.53 s/cm2, la dose d'implantation ionique étant de 3.5.10¹⁶ ions/cm² et l'intensité du faisceau d'ions étant de 5.5 mA.

11. Procédé selon l'une des revendications 1 à 10, **caractérisé en ce que** le masque (6) est une feuille de matériau dans laquelle le contour du marquage anti-contrefaçon a été découpé, cette feuille de matériau étant ensuite fixée sur la surface supérieure (2) ou inférieure (4) de l'objet (1) au moins partiellement transparent dans laquelle on souhaite structurer le motif.

12. Procédé selon l'une des revendications 1 à 10, **caractérisé en ce que** le masque (6) déposé sur la surface supérieure (2) ou inférieure (4) de l'objet (1) au moins partiellement transparent est une couche métallique créée par métallisation.

13. Procédé selon la revendication 12, **caractérisé en ce que** la métallisation est réalisée par évaporation sous vide au moyen de l'une des techniques suivantes : dépôt physique en phase vapeur (Physical Vapor Déposition ou PVD), dépôt chimique en phase vapeur (Chemical Vapor Déposition ou CVD), dépôt chimique en phase vapeur assisté par plasma (Plasma Enhanced Chemical Vapor Déposition).

14. Procédé selon la revendication 13, **caractérisé en ce que** la couche métallique est une couche de nitrure de chrome CrN dont l'épaisseur est comprise entre 1 et 1500 nm.

15. Procédé selon l'une des revendications 12 à 14, **caractérisé en ce que** la au moins une ouverture (14) dont le contour correspond au profil du marquage anti-contrefaçon que l'on souhaite structurer dans l'objet (1) au moins partiellement transparent est ménagée dans la couche métallique par photolithographie.

16. Procédé selon l'une des revendications 1 à 15, **caractérisé en ce que** l'objet (1) au moins partiellement transparent est une glace de montre.

17. Objet (1) au moins partiellement transparent dans l'épaisseur duquel est structuré un marquage anti-contrefaçon (18), ce marquage anti-contrefaçon (18) induisant une variation de la réflectivité de l'objet (1) imperceptible à l'œil nu mais pouvant être mis en évidence en l'éclairant au moyen d'une source lumineuse (20) à large spectre.
